# EUROPEAN PATENT SPECIFICATION

(11) **EP 0 887 849 B1**
(45) Date of publication and mention of the grant of the patent: **08.07.2009**
(21) Application number: 97308162.3
(22) Date of filing: 15.10.1997
(51) Int. Cl.: H01L 21/3205

(54) **Method for fabricating capacitor for semiconductor device**
Herstellungsverfahren von einem Kondensator für eine Halbleitervorrichtung
Procédé de fabrication d'un condensateur pour un dispositif semiconducteur

(30) Priority: 25.04.1997 KR 9715531
(43) Date of publication of application: 30.12.1998
(73) Proprietor: SAMSUNG ELECTRONICS CO., LTD., Suwon-City, Kyungki-do (KR)
(72) Inventor: Kang, Chang-Seok, Paldal-gu, Suwon-City, Kyungki-do (KR)
(74) Representative: Neill, Alastair William

(56) References cited:
- US-A- 5 335 138
- US-A- 5 366 920
- US-A- 5 385 866

## Description

The present invention relates to a method for fabricating a semiconductor device, and more particularly, to a method for fabricating a capacitor for a semiconductor device having a dielectric film of a high-dielectric constant.

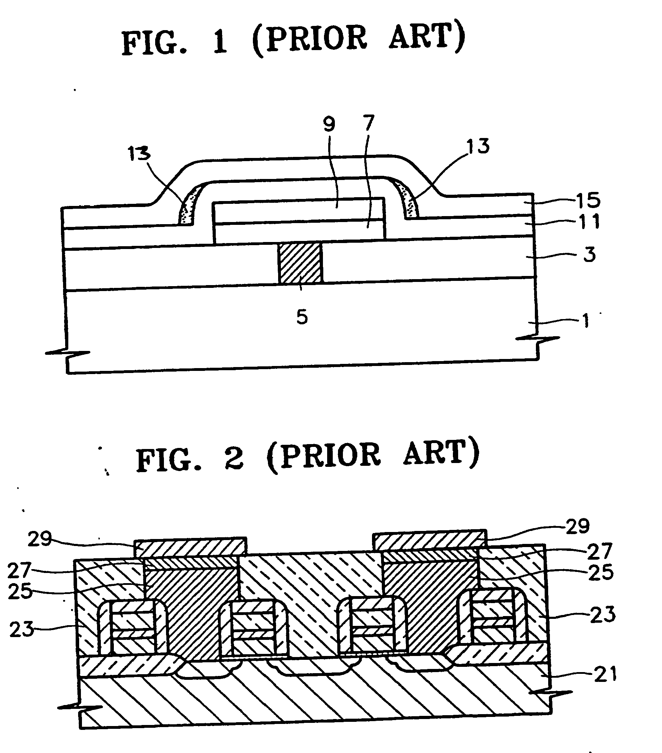

With increased integration of a semiconductor device such as a dynamic random access memory (DRAM) or a ferroelectric random access memory (FRAM), high dielectric constant materials such as PZT (PbZrTiO₃) and BST (BaSrTiO₃) have been applied to a dielectric film for a capacitor. In this case, a Pt-group metal or an oxide thereof is chiefly used as a first conductive layer of the capacitor adopting the high dielectric constant materials for the dielectric film. However, since the first conductive layer of the capacitor reacts with a polysilicon layer used as a contact plug, a conductive barrier layer for preventing such reaction is necessary between the first conductive layer and the polysilicon layer. An example of using the conductive barrier layer has been proposed in an article entitled "A stacked capacitor with (BaxSr1-x) TiO3 for 256M DRAM," Koyama et. al., IEDM 823-826, 1991, which is described with reference to Figure 1.

Figure 1 is a sectional view for illustrating a conventional capacitor for a semiconductor device.

In detail, an insulating layer 3 having a contact hole is formed on a semiconductor substrate 1. A contact plug 5 made of a polysilicon layer is buried in the contact hole. A barrier layer 7 connected to the contact plug 5 and made of tantalum (Ta) is formed over the contact hole, and a first conductive layer 9 of the capacitor made of Pt is formed on the barrier layer 7. A dielectric layer 11 and a sidewall insulating layer 13 are formed on the first conductive layer 9, and a second conductive layer 15 is formed over the entire surface of the semiconductor substrate where the dielectric layer 11 and the sidewall insulating layer 13 are formed.

The conventional capacitor shown in Figure 1 includes the barrier layer 7 for preventing the reaction between the first conductive layer 9 and the contact plug 5. However, since the capacitor shown in Figure 1 has the exposed sidewalls of the first conductive layer 9 and barrier layer 7, the barrier layer 7 is oxidized when depositing the dielectric layer 11 to then be a tantalum oxide layer (Ta₂O₅) which is a non-conductive material. Therefore, the contact resistance of the first conductive layer 9 is increased, and thus the conventional capacitor shown in Figure 1 is difficult to be used as a capacitor.

To address the above-described problem, a method of recessing a contact plug has been proposed in the U.S. Patent No.5,478,772, which is described with reference to Figure 2.

Figure 2 is a sectional view for illustrating another conventional capacitor for a semiconductor device.

In detail, an insulating layer 23 having a contact hole is formed on a semiconductor substrate 21. A silicon plug 25 and a barrier layer 27 made of a Ta layer are sequentially buried in the contact hole. A first conductive layer 29 made of a Pt layer is formed on the barrier layer 27. The conventional capacitor shown in Figure 2 has the barrier layer 27 formed at a different position from the barrier layer 7 shown in Figure 1. That is, the barrier layer 27 is buried in the contact hole, which prevents from exposing sidewalls of the barrier layer 27.

However, it is difficult to form the barrier layer 27 according to the manufacturing method of the conventional capacitor shown in Figure 2. In other words, to form the barrier layer 27 buried in the contact hole, a conductive material for a barrier layer 27 is deposited over the entire surface of the semiconductor substrate 21 and then a chemical-mechanical polishing (CMP) or etch-back process must be additionally conducted thereon. Also, when misalignment occurs during a patterning process for forming the first conductive layer 29, the barrier layer 27 is oxidized during a subsequent process of depositing a dielectric layer to then become a non-conductive material. If the barrier layer 27 becomes the non-conductive material in such a manner, the contact resistance of the first conductive layer 29 is increased, and the yield of the semiconductor device is sharply lowered.

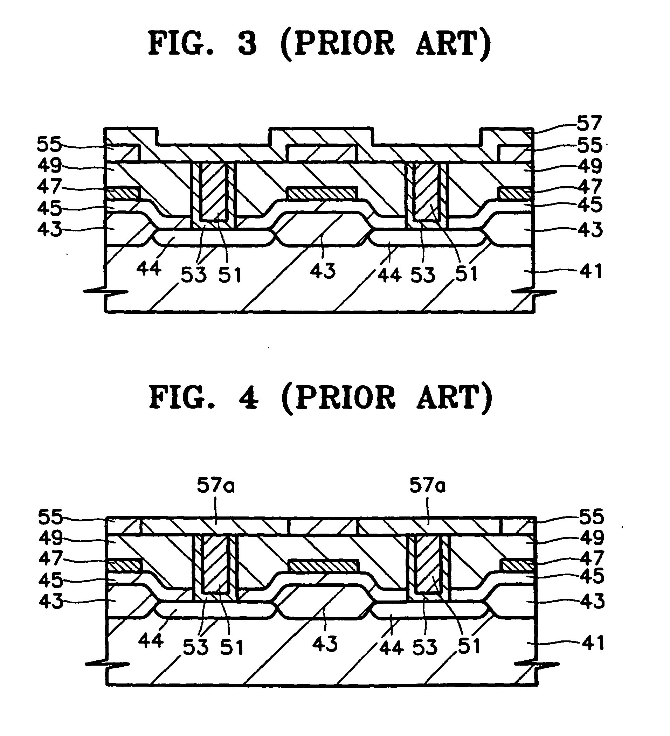

To address such problems, a method of burying a conductive layer between barrier layers has been disclosed in the Japanese Patent laid-open Publication No. 1995-22518, which will be described with reference to Figures 3 and 4.

Figures 3 and 4 are sectional views for illustrating a method for fabricating still another conventional capacitor for a semiconductor device.

In Figure 3, a field oxide layer 43, a source region 44, an interlayer insulating layer 45 and a bit line 47 are formed on a semiconductor substrate 41.

An interlayer connecting conductor 51 and an adhesion layer 53 are connected to the source region 44 by a contact hole formed through an planarization layer 49 and the interlayer insulating layer 45. Also, an insulating layer pattern 55 is formed on the planarization layer 49, and a first conductive layer 57 made of a Pt layer is formed over the entire surface of the semiconductor substrate 41 where the insulating layer pattern 55 is formed.

Referring to Figure 4, the first conductive layer 57 is selectively etched by a CMP process to form a first conductive layer pattern 57a between the insulating layer patterns 55.

However, according to the manufacturing method of the conventional capacitor for a semiconductor device shown in Figures 3 and 4, since the first conductive layer 57 made of a Pt layer is CMP-etched, fine scratches are formed on the Pt layer by a polishing agent used in CMP process, which deteriorates the surface roughness of the Pt layer. Also, residues remain on the Pt layer after performing the CMP process. Then, the interface between the Pt layer and a dielectric layer to be formed later is deteriorated, which degrades the electrical characteristics of the capacitor for a semiconductor device.

US-A-5 335 138 discloses a high storage capacity capacitor for a semiconductor structure including a barrier layer formed on a polysilicon electrode, a lower electrode, a dielectric layer, and an upper electrode.

US-A-5 385 866 discloses a method of polishing a non-planar surface layer on a semiconductor substrate by providing an oxidized boron nitride polish stop layer on the semiconductor substrate, forming a non-planar surface layer on the oxidized boron nitride polish stop layer, the oxidized boron nitride polish stop layer being polish selective relative to the non-planar surface layer, and polishing the non-planar surface layer until the oxidized boron nitride polish stop layer is reached.

It is an aim of preferred embodiments of the present invention to provide a method for fabricating a capacitor for a semiconductor device which can prevent oxidation of a barrier layer and suppress the increase of contact resistance.

According to the present invention in a first aspect, there is provided a method for fabricating a capacitor for a semiconductor device comprising the steps of:
a) forming a first conductive layer on a semiconductor substrate;
b) forming an etch-stop layer over said first conductive layer;
c) forming a first conductive layer and etch-stop layer pattern having an opening on said semiconductor substrate;
d) forming an interlayer insulating layer over the entire surface of the semiconductor substrate so as to fill said opening and cover the first conductive layer and etch-stop layer pattern;
e) forming an interlayer insulating layer pattern in said opening by etching the interlayer insulating layer using the etch-stop layer pattern as an etching endpoint;
f) continuing the etching of the interlayer insulating pattern until the surface thereof is below the surface of the etch-stop;
g) removing the etch-stop layer pattern thus exposing the first conductive layer pattern which forms the lower electrode of the capacitor;
h) forming a dielectric layer over the entire surface of the semiconductor substrate where the first conductive layer pattern and the interlayer insulating layer pattern are formed; and
i) forming a second conductive layer on the dielectric layer this second conductive layer forming the upper electrode of the capacitor.

Further features of the present invention are set out in the dependent claims.

The present invention will become more apparent by describing in detail a preferred embodiment thereof, by way of example only, with reference to the attached drawing(s); in which:
Figure 1 is a sectional view of a conventional capacitor for a semiconductor device;
Figure 2 is a sectional view of another conventional capacitor for a semiconductor device;
Figures 3 and 4 are sectional views for illustrating a method for fabricating still another conventional capacitor for a semiconductor device;
Figures 5 through 9 are sectional views for illustrating a method for fabricating a capacitor for a semiconductor device according to a first embodiment of the present invention;
Figures 10 through 17 are sectional views for illustrating a method for fabricating a capacitor for a semiconductor device according to a second embodiment of the present invention; and
Figure 18 is a sectional view for illustrating a method for fabricating a capacitor for a semiconductor device according to a third embodiment of the present invention.

### EMBODIMENT 1

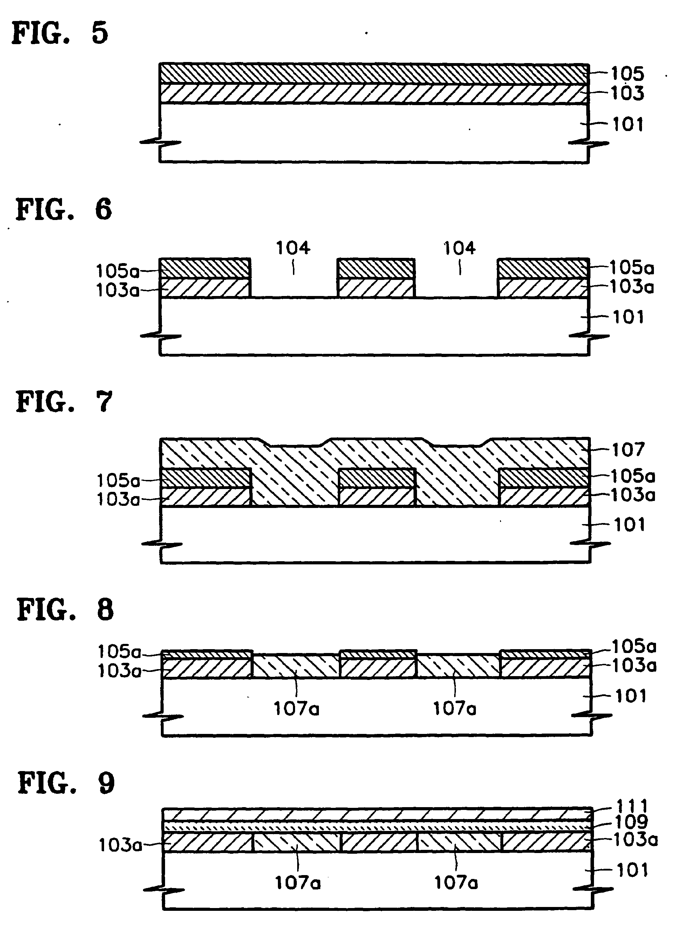

Figures 5 through 9 are sectional views for illustrating a method for fabricating a capacitor for a semiconductor device according to a first embodiment of the present invention.

In Figure 5, a first conductive layer 103 was formed on a semiconductor substrate 101 to a thickness of 100∼5000A. The first conductive layer 103 was formed of a single or multiple layer of a Pt-group metal such as Pt, Ru, Ir or Os and an oxide of the Pt-group metal such as IrO₂, RuO₂ or OsO₂. The first conductive layer 103 was also formed of a single or multiple layer of a refractory metal such as W, TiN, TiSiN, TaSiN, TaAlN or WN and an oxide of the refractory metal. Subsequently, an etch-stop layer 105 which is a feature of the present invention was formed on the first conductive layer 103 to a thickness of 100∼5000A. The etch-stop layer 105 was employed a material having a large etching selectivity when etching the first conductive layer 103 and an interlayer insulating layer to be formed later. In this embodiment, a material having a large etching selectivity with respect to the interlayer insulating layer, e.g., SiN, TiN or BN, was employed as the etch-stop layer 105. Here, to improve the adhesiveness between the first conductive layer 103 and the etch-stop layer 105, an adhesion layer (not shown) may be formed on the first conductive layer 103 prior to formation of the etch-stop layer 105, if necessary. Here, the adhesion layer is formed of Ti, TiSiN, TaSiN, TaAlN or TiN.

In Figure 6, the etch-stop layer 105 and the first conductive layer 103 were patterned to form an etch-stop layer pattern 105a and a first conductive layer pattern 103a having a contact hole 104 exposing the surface of the semiconductor substrate 101.

In Figure 7, an interlayer insulating layer 107 was formed over the entire surface of the semiconductor substrate 101 to fill the contact hole 104 and cover the etch-stop layer pattern 105a. The interlayer insulating layer 107 was formed using silicon oxide, undoped silicate glass (USG), spin on glass (SOG) or borophosphosilicate glass (BPSG).

In Figure 8, the interlayer insulating layer 107 was etched by a CMP or etch-back process with setting the etch-stop layer pattern 105a as an etching endpoint. Then, an interlayer insulating layer pattern 107a was formed between the conductive layer patterns 103a.

In Figure 9, the etch-stop layer pattern 105a was removed. Subsequently, a dielectric layer 109 and a second conductive layer 111 were formed over the entire surface of the semiconductor substrate 101 where the conductive layer pattern 103a and the interlayer insulating layer pattern 107a are formed. The dielectric layer 109 was formed of one selected from the group consisting of Ta₂O₅, SiO₂, SrTiO₃, (Ba, Sr)TiO₃, PbZrTiO₃, SrBi₂Ta₂O₉, (Pb, La)(Zr, Ti)O₃, Bi₄Ti₃O₁₂ and the combination thereof. The second conductive layer 111 was formed of a single or multiple layer of a Pt-group metal such as Pt, Ru, Ir or Os and an oxide of the Pt-group metal such as IrO₂, RuO₂ or O_{S}O₂. The second conductive layer 111 was also formed of a single or multiple layer of a refractory metal such as W, TiN, TiSiN, TaSiN, TaAlN or WN and an oxide of the refractory metal.

### EMBODIMENT 2

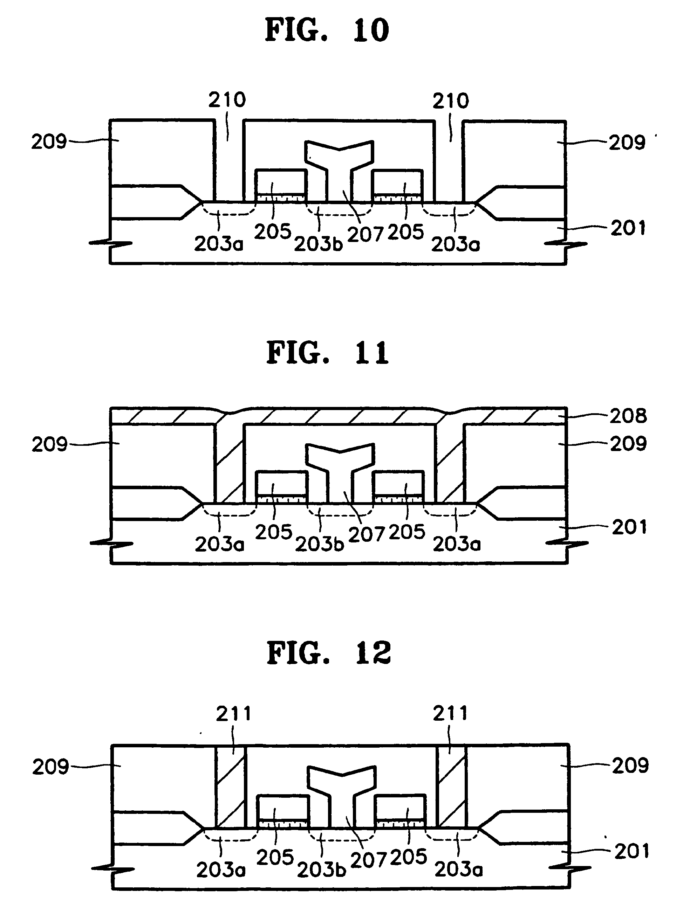

Figures 10 through 17 are sectional views for illustrating a method for fabricating a capacitor for a semiconductor device according to a second embodiment of the present invention.

In Figure 10, a first interlayer insulating layer 209 was formed on a semiconductor substrate 201 where a transistor having a source region 203a, a drain region 203b and a gate electrode 205, and a bit line 207 were formed. Subsequently, the first interlayer insulating layer 209 deposited on the source region 203a was etched by a photolithography process to form a contact hole 210 for connecting a first conductive layer of a capacitor to be formed later.

In Figure 11, a conductive material layer 208 was formed on the substrate where the contact hole 210 is formed. The conductive material layer 208 was formed of one selected from the group consisting of a refractory metal, polysilicon, a Pt-group metal, metal silicide and the combination thereof.

In Figure 12, the conductive material layer 208 was etched back or CMP-processed to form a contact plug layer 211 filling the inside of the contact hole 210.

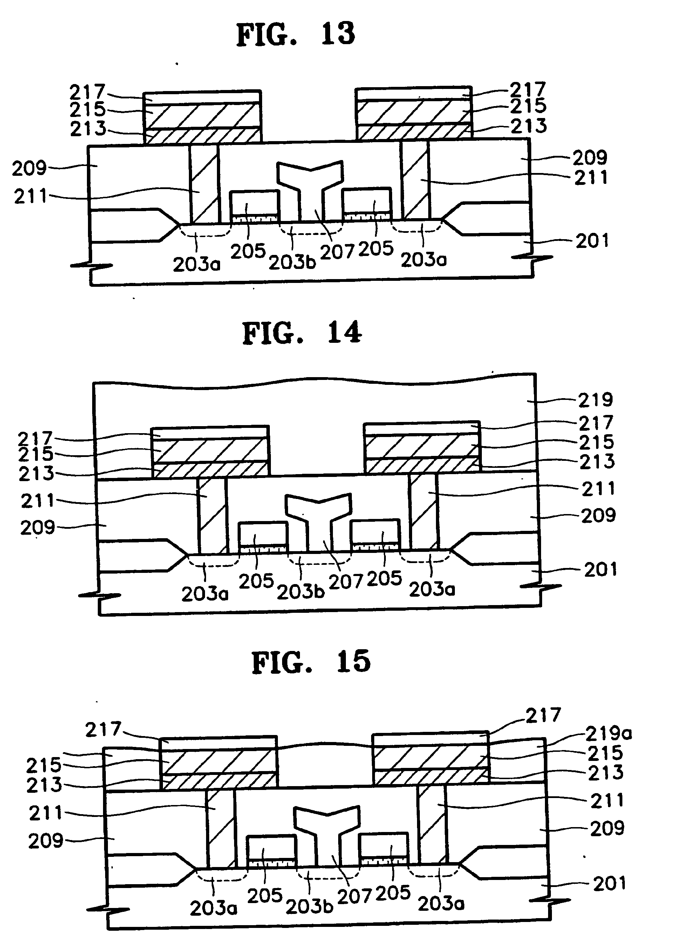

In Figure 13, a barrier layer, a first conductive layer and an etch-stop layer were sequentially formed over the entire surface of the resultant structure having the contact plug layer 211 and then are patterned by the photolithography process to form a barrier layer pattern 213 a first conductive layer pattern 215 and an etch-stop layer pattern 217 exposing the surface of the first interlayer insulating layer pattern 209. Here, an adhesion layer (not shown) of Ti, TiSiN, TaSiN, TaAlN or TiN may further formed on the first conductive layer pattern 215 to improve adhesiveness between the etch-stop layer pattern 217 and the first conductive layer pattern 215.

The barrier layer pattern 213 was formed of one selected from the group consisting of a conducive oxide, a refractory metal, a Pt-group metal, a refractory metallic silicide, a refractory metallic nitride and the combination thereof. For example, the barrier layer pattern 213 was formed of one selected from the group consisting of Ti, W, Ir, Ru, TiSiₓ, WSi, TiSiN, TaSiN, IrO₂, RuO₂, WN, TiN, TaAlN and the combination thereof. The first conductive layer pattern 215 was formed of a single or multiple layer of a Pt-group metal such as Pt, Ru, Ir or Os and an oxide of the Pt-group metal such as IrO₂, RuO₂ or OsO₂. The first conductive layer pattern 215 was also formed of a single or multiple layer of a refractory metal such as W, TiN, TiW, TiSiN, TaSiN, TaAlN or WN and an oxide of the refractory metal.

The etch-stop layer 217 was formed of a material having a large etching selectivity with respect to a second interlayer insulating layer to be formed later, e.g., SiN, TiN or BN, for the purpose of protecting the first conductive layer pattern 215 when performing a CMP or etch-back process. Particularly, in the case of employing the SiN, the etch-stop layer pattern 217 was formed to a thickness of 100∼5000A.

In Figure 14, a second interlayer insulating layer 219 was formed to a thickness of 1000∼5000A over the entire surface of the semiconductor substrate 201 so as to sufficiently fill the spaces among patterns consisting of barrier layer pattern 213, the first conductive layer pattern 215 and the etch-stop layer pattern 217. The second interlayer insulating layer 219 was formed using silicon oxide, undoped silicate glass (USG), spin on glass (SOG) or borophosphosilicate glass (BPSG).

In Figure 15, the second interlayer insulating layer 219 was etched by a CMP or etch-back process with setting the etch-stop layer pattern 217 as an etching endpoint. Then, a second interlayer insulating layer pattern 219a was formed between the barrier layer patterns 213 and the first conductive layer patterns 215.

Particularly, as shown in Figure 15, if the etch-stop layer pattern 217 is used during the CMP or etch-back process as an etching endpoint, the damage of the first conductive layer pattern 215 is prevented and a process margin is broadened. Also, the interface characteristic between the first conductive layer pattern 215 and a dielectric layer to be formed later is improved. Therefore, the electrical characteristics of the capacitor for a semiconductor device can be enhanced.

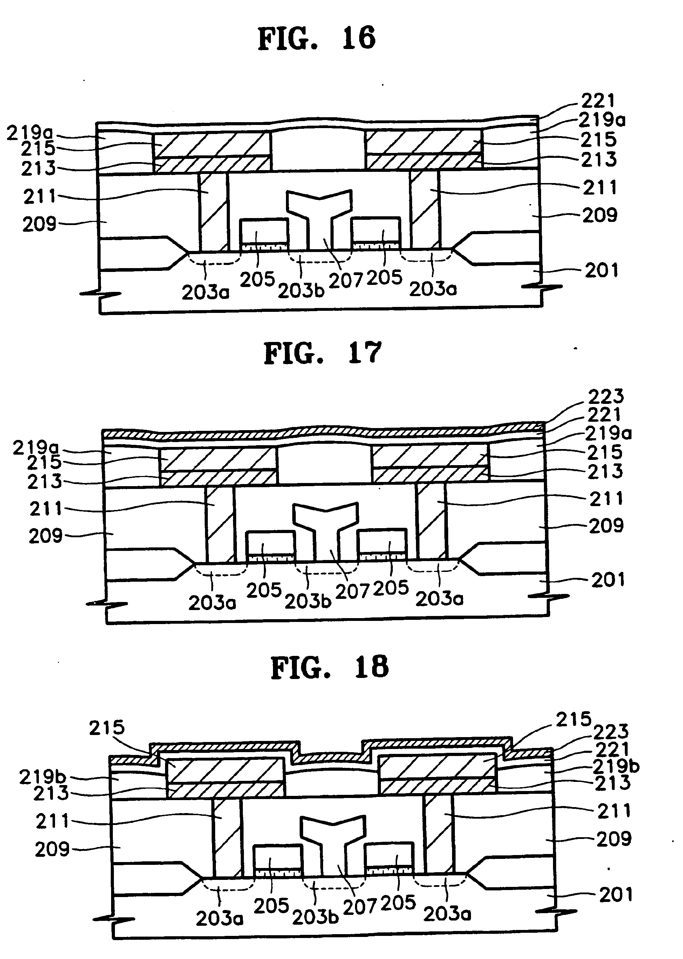

In Figure 16, the etch-stop layer pattern 217 was removed by a wet-etching process using a phosphoric acid solution. Subsequently, a dielectric layer 221 was formed over the entire surface of the semiconductor substrate 201 where the first conductive layer pattern 215 and the second interlayer insulating layer pattern 219a are formed. The dielectric layer 221 was formed of one selected from the group consisting of Ta₂O₅, SiO₂, SrTiO₃, (Ba, Sr)TiO₃, PbZrTiO₃, SrBi₂Ta₂O₉, (Pb, La)(Zr, Ti)O₃, Bi₄Ti₃O₁₂ and the combination thereof. The dielectric layer 221 was formed by a sputtering method or a chemical vapor deposition (CVD) method.

In Figure 17, a second conductive layer 223 was formed on the dielectric layer 221, thereby completing the capacitor for a semiconductor device. The second conductive layer 223 was formed of a single or multiple layer of a Pt-group metal such as Pt, Ru, Ir or Os and an oxide of the Pt-group metal such as IrO₂, RuO₂ or OsO₂. The second conductive layer 223 was also formed of a single or multiple layer of refractory metal such as W, TiN, TiSiN, TaSiN, TaAlN or WN and an oxide of the refractory metal.

### EMBODIMENT 3

Figure 18 is a sectional view for illustrating a method for fabricating a capacitor for a semiconductor device according to a third embodiment of the present invention. In Figure 18, like numbers are used for designating like or equivalent portions in Figures 10 through 17.

First, the same steps as shown in Figures 10 through 15 of the second embodiment of the present invention were conducted. Subsequently, the second interlayer insulating layer pattern 219a was further etched to form a third interlayer insulating layer pattern 219b. After the etch-stop layer pattern 217 was removed by a wet-etching process using a phosphoric acid solution, the dielectric layer 221 and the second conductive layer 223 shown in Figure 18 were formed, thereby completing the capacitor for a semiconductor device.

As described above, according to the capacitor fabricating method for a semiconductor device of the preferred embodiments of the present invention, an etch-stop layer is formed on a first conductive layer pattern and an interlayer insulating layer is then etched with setting the etch-stop layer as an etching endpoint. Accordingly, the first conductive layer pattern is not damaged nor consumed. Also, since the barrier layer pattern is not exposed to the air in a subsequent process of forming a dielectric layer, the barrier layer pattern is not oxidized, thereby suppressing the increase of contact resistance.

The present invention is not limited to the above-described illustrative embodiments and various alterations and modifications may be made by one skilled in the art within the scope of the invention.

## Claims

1. A method for fabricating a capacitor for a semiconductor device comprising the steps of:
a) forming a first conductive layer (103, 215) on a semiconductor substrate (101, 201);
b) forming an etch-stop layer (105, 217) over said first conductive layer;
c) forming a first conductive layer (103, 215) and etch-stop layer (105, 217) pattern having an opening (104, 210) on said semiconductor substrate (101, 201);
d) forming an interlayer insulating layer (107, 219) over the entire surface of the semiconductor substrate (101, 201) so as to fill said opening and cover the first conductive layer and etch-stop layer pattern (105, 217);
e) forming an interlayer insulating layer pattern (107a, 219a) in said opening by etching the interlayer insulating layer (107, 219) using the etch-stop layer pattern (105, 217) as an etching endpoint;
f) continuing the etching of the interlayer insulating pattern until the surface thereof is below the surface of the etch-stop layer;
g) removing the etch-stop layer pattern (105, 217) thus exposing the first conductive layer pattern which forms the lower electrode of the capacitor;
h) forming a dielectric layer (109, 221) over the entire surface of the semiconductor substrate (109, 221) where the first conductive layer pattern (103, 215) and the interlayer insulating layer pattern (107, 219) are formed; and
i) forming a second conductive layer (111, 223) on the dielectric layer (109, 221) this second conductive layer forming the upper electrode of the capacitor.

2. The method according to claim 1, further comprising the steps of:
prior to step a) of claim 1;
forming a first interlayer insulating layer (209) having a contact hole (210) on a semiconductor substrate (201); and
forming a contact plug (211) buried in the contact hole (210);
then sequentially forming a barrier layer (213) and forming the first conductive layer (215) and the etch-stop layer (217) of steps a) and b) of claim 1 on the first insulating layer and contact plug (211);
forming a pattern of the barrier layer (213), and forming said first conductive layer (215), and etch-stop layer (217) pattern of step c) of claim 1 directly under the barrier layer pattern, and on the contact plug layer (211) and the first interlayer insulating layer (209) so that the pattern is electrically connected to the contact plug layer (211);
forming said interlayer insulating layer (219) of step d) of claim 1;
and said interlayer insulating layer pattern (219) of step e) of claim 1 and continuing with steps f) to i) of claim 1.

3. A method according to claim 1 or 2, wherein the interlayer insulating layer (107, 219) is formed of one selected from the group consisting of silicon oxide, USG, SOG and BPSG.

4. A method according to any preceding claim, wherein the etch stop layer pattern (105, 217) is formed of one selected from the group of SiN, TiN and BN.

5. A method according to any one of claim 1, and claims 3 or 4, when dependent on claim 1 wherein the etch stop layer pattern (105, 217) is formed to a thickness of 100∼5000A.

6. A method according to any preceding claim, wherein an adhesion layer is further formed on the first conductive layer pattern (103, 215) to improve adhesiveness with the etching stopping layer pattern (105, 217).

7. A method according to claim 6, wherein the adhesion layer is formed of Ti, TiSiN, TaSiN, TaAlN or TiN.

8. A method according to any preceding claim, wherein the etching of the interlayer insulating layer (107, 219) is conducted using a CMP or etch-back process.

9. A method according to any preceding claim, wherein the interlayer insulating layer pattern (107, 219) is further etched to have a smaller height than the first conductive layer pattern (103, 215), after etching the interlayer insulating layer (107, 219).

10. A method according to any preceding claim, wherein the dielectric layer (109, 221) is formed of one selected from the group consisting of Ta₂O₅, SiO₂, SrTiO₃, (Ba, Sr)TiO₃, PbZrTiO₃, SrBi₂Ta₂O₉, (Pb, La)(Zr, Ti)O₃, Bi₄Ti₃O₁₂ and the combination thereof.

11. A method according to any preceding claim, wherein the first conductive layer pattern (103, 215) and the second conductive layer (111, 223) are formed of one selected from the group consisting of a single or multiple layer of a Pt-group metal and an oxide of the Pt-group metal, and a single or multiple layer of a refractory metal and an oxide of the refractory metal.

12. A method according to claim 11, wherein the oxide of the Pt-group metal is one selected from the group consisting of IrO₂, RuO₂ and OsO₂.

13. A method according to claim 11, wherein the refractory metal is one selected from the group consisting of W, TiN, TiW and WN.

14. A method according to claim 2 or claims 3-13 when dependent on claim 2, wherein the contact plug layer (211) is formed of one selected from the group consisting of a refractory metal, polysilicon, a Pt-group metal, metallic silicide and the combination thereof.

15. A method according to claim 2 or claims 3-14 when dependent on claim 2, wherein the barrier layer pattern is formed of one selected from the group consisting of a conductive oxide, a refractory metal, a Pt-group metal, a refractory metallic silicide, a refractory metallic nitride and the combination thereof.

16. A method according to claim 2 or claims 3-15 when dependent on claim 2, wherein the barrier layer pattern (213) is formed of one selected from the group consisting of Ti, W, Ir, Ru, TiSiₓ, WSi, TiSiN, TaSiN, IrO₂, RuO₂, WN, TiN and the combination thereof.

## Patentansprüche

1. Verfahren zum Herstellen eines Kondensators für ein Halbleiterbauelement, umfassend die folgenden Schritte:
a) Ausbilden einer ersten leitenden Schicht (103, 215) auf einem Halbleitersubstrat (101, 201);
b) Ausbilden einer Ätzstoppschicht (105, 217) über der ersten leitenden Schicht;
c) Ausbilden einer Struktur aus der ersten leitenden Schicht (103, 215) und Ätzstoppschicht (105, 217) mit einer Öffnung (104, 210) auf dem Halbleitersubstrat (101, 201);
d) Ausbilden einer Zwischenschicht-Isolierschicht (107, 219) über der ganzen Oberfläche des Halbleitersubstrats (101, 201), um die Öffnung zu füllen und die Struktur (105, 217) aus der ersten leitenden Schicht und Ätzstoppschicht zu bedecken;
e) Ausbilden einer Zwischenschicht-Isolierschicht-Struktur (107a, 219a) in der Öffnung durch Ätzen der Zwischenschicht-Isolierschicht (107, 219) unter Verwendung der Ätzstoppschichtstruktur (105, 217) als einen Ätzendpunkt;
f) Fortsetzen des Ätzens der Zwischenschicht-Isolierstruktur, bis sich die Oberfläche davon unter der Oberfläche der Ätzstoppschicht befindet;
g) Beseitigen der Ätzstoppschichtstruktur (105, 217) und **dadurch** Exponieren der ersten leitenden Schichtstruktur, die die untere Elektrode des Kondensators bildet;
h) Ausbilden einer Dielektrikumsschicht (109, 221) über der ganzen Oberfläche des Halbleitersubstrats (109, 221), wo die erste leitende Schichtstruktur (103, 215) und die Zwischenschicht-Isolierschicht-Struktur (107, 219) ausgebildet sind; und
i) Ausbilden einer zweiten leitenden Schicht (111, 223) auf der Dielektrikumsschicht (109, 221), wobei diese zweite leitende Schicht die obere Elektrode des Kondensators bildet.

2. Verfahren nach Anspruch 1, weiterhin umfassend die folgenden Schritte:
vor dem Schritt a) von Anspruch 1;
Ausbilden einer ersten Zwischenschicht-Isolierschicht (209) mit einem Kontaktloch (210) auf einem Halbleitersubstrat (201); und
Ausbilden eines in dem Kontaktloch (210) vergrabenen Kontaktplugs (211);
dann sequentielles Ausbilden einer Barrierenschicht (213) und Ausbilden der ersten leitenden Schicht (215) und der Ätzstoppschicht (217) der Schritte a) und b) von Anspruch 1 auf der ersten Isolierschicht und dem Kontaktplug (211) ;
Ausbilden einer Struktur der Barrierenschicht (213) und Ausbilden der ersten leitenden Schicht (215) und Ätzstoppschichtstruktur (217) von Schritt c) von Anspruch 1 direkt unter der Barrierenschichtstruktur und auf der Kontaktplugschicht (211) und der ersten Zwischenschicht-Isolierschicht (209), so daß die Struktur elektrisch mit der Kontaktplugschicht (211) verbunden ist;
Ausbilden der Zwischenschicht-Isolierschicht (219) von Schritt d) von Anspruch 1;
und der Zwischenschicht-Isolierschicht-Struktur (219) von Schritt e) von Anspruch 1 und Fortsetzung mit Schritten f) bis i) von Anspruch 1.

3. Verfahren nach Anspruch 1 oder 2, wobei die Zwischenschicht-Isolierschicht (107, 219) aus einem ausgewählt aus der Gruppe bestehend aus Siliziumoxid, USG, SOG und BPSG ausgebildet wird.

4. Verfahren nach einem der vorhergehenden Ansprüche, wobei die Ätzstoppschichtstruktur (105, 217) aus einem ausgewählt aus der Gruppe von SiN, TiN und BN ausgebildet wird.

5. Verfahren nach einem des Anspruchs 1 und der Ansprüche 3 oder 4 bei Abhängigkeit von Anspruch 1, wobei die Ätzstoppschichtstruktur (105, 217) bis zu einer Dicke von 100∼5000 A ausgebildet wird.

6. Verfahren nach einem der vorhergehenden Ansprüche, wobei weiterhin eine Haftschicht auf der ersten leitenden Schichtstruktur (103, 215) ausgebildet wird, um die Haftung mit der Ätzstoppschichtstruktur (105, 217) zu verbessern.

7. Verfahren nach Anspruch 6, wobei die Haftschicht aus Ti, TiSiN, TaSiN, TaAln oder TiN ausgebildet wird.

8. Verfahren nach einem vorhergehenden Anspruch, wobei das Ätzen der Zwischenschicht-Isolierschicht (107, 219) unter Verwendung eines CMP- oder Rückätzprozesses durchgeführt wird.

9. Verfahren nach einem vorhergehenden Anspruch, wobei die Zwischenschicht-Isolierschicht-Struktur (107, 219) weiterhin so geätzt wird, dass sie nach dem Ätzen der Zwischenschicht-Isolierschicht (107, 219) eine kleinere Höhe als die erste leitende Schichtstruktur (103, 215) aufweist.

10. Verfahren nach einem vorhergehenden Anspruch, wobei die Dielektrikumsschicht (109, 221) aus einem ausgewählt aus der Gruppe bestehend aus Ta₂O₅, SiO₂, SrTiO₃, (Ba, Sr) TiO₃, PbZrTiO₃, SrBi₂Ta₂O₉, (Pb, La) (Zr, Ti) O₃, Bi₄Ti₃O₁₂ und der Kombination davon ausgebildet wird.

11. Verfahren nach einem vorhergehenden Anspruch, wobei die erste leitende Schichtstruktur (103, 215) und die zweite leitende Schicht (111, 223) aus einem ausgewählt aus der Gruppe bestehend aus einer Einfach- oder Mehrfachschicht eines Metalls aus der Pt-Gruppe und einem Oxid des Metalls aus der Pt-Gruppe und einer Einfach- oder Mehrfachschicht aus einem feuerfesten Metall und einem Oxid des feuerfesten Metalls ausgebildet werden.

12. Verfahren nach Anspruch 11, wobei das Oxid des Metalls aus der Pt-Gruppe eines ist ausgewählt aus der Gruppe bestehend aus IrO₂, RuO₂ und OsO₂.

13. Verfahren nach Anspruch 11, wobei das feuerfeste Metall eines ist ausgewählt aus der Gruppe bestehend aus W, TiN, TiW und WN.

14. Verfahren nach Anspruch 2 oder Ansprüchen 3-13 bei Abhängigkeit von Anspruch 2, wobei die Kontaktplugschicht (211) aus einem ausgewählt aus der Gruppe bestehend aus einem feuerfesten Metall, Polysilizium, einem Metall aus der Pt-Gruppe, metallischem Silizid und der Kombination davon ausgebildet wird.

15. Verfahren nach Anspruch 2 oder Ansprüchen 3-14 bei Abhängigkeit von Anspruch 2, wobei die Barrierenschichtstruktur aus einem ausgewählt aus der Gruppe bestehend aus einem leitenden Oxid, einem feuerfesten Metall, einem Metall aus der Pt-Gruppe, einem feuerfesten metallischen Silizid, einem feuerfesten metallischen Nitrid und der Kombination davon ausgebildet wird.

16. Verfahren nach Anspruch 2 oder Ansprüchen 3-15 bei Abhängigkeit von Anspruch 2, wobei die Barrierenschichtstruktur (213) aus einem ausgewählt aus der Gruppe bestehend aus Ti, W, Ir, Ru, TiSiₓ, WSi, TiSiN, TaSiN, IrO₂, RuO₂, WN, TiN und der Kombination davon ausgebildet wird.

## Revendications

1. Procédé pour fabriquer un condensateur pour un dispositif semi-conducteur comprenant les étapes consistant à :
a) former une première couche conductrice (103, 215) sur un substrat semi-conducteur (101, 201) ;
b) former une couche d'arrêt de gravure (105, 217) par-dessus ladite première couche conductrice ;
c) former un motif de première couche conductrice (103, 215) et de couche d'arrêt de gravure (105, 217) ayant une ouverture (104, 210) sur ledit substrat semi-conducteur (101, 201) ;
d) former une couche isolante intermédiaire (107, 219) sur la totalité de la surface du substrat semi-conducteur (101, 201) de manière à remplir ladite ouverture et recouvrir le motif de première couche conductrice et de couche d'arrêt de gravure (105, 217) ;
e) former un motif de couche isolante intermédiaire (107a, 219a) dans ladite ouverture en décapant la couche isolante intermédiaire (107, 219) en utilisant le motif de couche d'arrêt de gravure (105, 217) comme limite de décapage ;
f) poursuivre le décapage du motif isolant intermédiaire jusqu'à ce que la surface de celui-ci soit en dessous de la surface de la couche d'arrêt de gravure ;
g) retirer le motif de couche d'arrêt de gravure (105, 217) pour exposer ainsi le motif de première couche conductrice qui forme l'électrode inférieure du condensateur ;
h) former une couche diélectrique (109, 221) sur la totalité de la surface du substrat semi-conducteur (109, 221) où le motif de première couche conductrice (103, 215) et le motif de couche isolante intermédiaire (107, 219) sont formés ; et
i) former une seconde couche conductrice (111, 223) sur la couche diélectrique (109, 221), cette seconde couche conductrice formant l'électrode supérieure du condensateur.

2. Procédé selon la revendication 1, comprenant en outre les étapes consistant à :
avant l'étape a) de la revendication 1 :
former une première couche isolante intermédiaire (209) comportant un trou de contact (210) sur un substrat semi-conducteur (201) ; et
former une fiche de contact (211) enterrée dans le trou de contact (210) ;
puis, successivement, former une couche barrière (213) et former la première couche conductrice (215) et la couche d'arrêt de gravure (217) des étapes a) et b) de la revendication 1 sur la première couche isolante et la fiche de contact (211) ;
former un motif de la couche barrière (213), et former ledit motif de première couche conductrice (215) et de couche d'arrêt de gravure (217) de l'étape c) de la revendication 1 juste en dessous du motif de couche barrière, et sur la couche de fiches de contact (211) et la première couche isolante intermédiaire (209) de telle sorte que le motif soit relié électriquement à la couche de fiches de contact (211) ;
former ladite couche isolante intermédiaire (219) de l'étape d) de la revendication 1 ;
et ledit motif de couche isolante intermédiaire (219) de l'étape e) de la revendication 1, et poursuivre avec les étapes f) à i) de la revendication 1.

3. Procédé selon la revendication 1 ou 2, dans lequel la couche isolante intermédiaire (107, 219) est composée d'un matériau choisi dans le groupe constitué par l'oxyde de silicium, l'USG, le SOG et le BPSG.

4. Procédé selon l'une quelconque des revendications précédentes, dans lequel le motif de couche d'arrêt de gravure (105, 217) est composé d'un matériau choisi dans le groupe de SiN, TiN et BN.

5. Procédé selon l'une quelconque des revendications 1, et 3 et 4 lorsque dépendantes de la revendication 1, dans lequel le motif de couche d'arrêt de gravure (105, 217) est formé à une épaisseur de 100∼5000 Å.

6. Procédé selon l'une quelconque des revendications précédentes, dans lequel une couche d'adhérence est en outre formée sur le motif de première couche conductrice (103, 215) pour améliorer l'adhésivité avec le motif de couche d'arrêt de gravure (105, 217).

7. Procédé selon la revendication 6, dans lequel la couche d'adhérence est composée de Ti, TiSiN, TaSiN, TaAIN ou TiN.

8. Procédé selon l'une quelconque des revendications précédentes, dans lequel le décapage de la couche isolante intermédiaire (107, 219) est réalisé en utilisant un procédé CMP ou de gravure en retrait.

9. Procédé selon l'une quelconque des revendications précédentes, dans lequel le motif de couche isolante intermédiaire (107, 219) est en outre décapé pour avoir une hauteur inférieure à celle du motif de première couche conductrice (103, 215), après décapage de la couche isolante intermédiaire (107, 219).

10. Procédé selon l'une quelconque des revendications précédentes, dans lequel la couche diélectrique (109, 221) est composée d'un matériau choisi dans le groupe constitué par Ta₂O₅, SiO₂, SrTiO₃, (Ba, Sr) TiO₃, PbZrTiO₃, SrBi₂Ta₂O₉, (Pb, La) (Zr, Ti) O₃, Bi₄Ti₃O₁₂ et les combinaisons de ceux-ci.

11. Procédé selon l'une quelconque des revendications précédentes, dans lequel le motif de première couche conductrice (103, 215) et la seconde couche conductrice (111, 223) sont composés d'un matériau choisi dans le groupe constitué par une monocouche ou une multicouche d'un métal du groupe du platine et d'un oxyde du métal du groupe du platine, et une monocouche ou une multicouche d'un métal réfractaire et d'un oxyde du métal réfractaire.

12. Procédé selon la revendication 11, dans lequel l'oxyde du métal du groupe du platine est un oxyde choisi dans le groupe constitué par IrO₂, RuO₂ et OsO₂.

13. Procédé selon la revendication 11, dans lequel le métal réfractaire est un matériau choisi dans le groupe constitué par W, TiN, TiW et WN.

14. Procédé selon la revendication 2, ou les revendications 3 à 13 lorsque dépendantes de la revendication 2, dans lequel la couche de fiches de contact (211) est composée d'un matériau choisi dans le groupe constitué par un métal réfractaire, le silicium polycristallin, un métal du groupe du platine, un siliciure métallique et les combinaisons de ceux-ci.

15. Procédé selon la revendication 2, ou les revendications 3 à 14 lorsque dépendantes de la revendication 2, dans lequel le motif de couche barrière est composé d'un matériau choisi dans le groupe constitué par un oxyde conducteur, un métal réfractaire, un métal du groupe du platine, un siliciure métallique réfractaire, un nitrure métallique réfractaire et les combinaisons de ceux-ci.

16. Procédé selon la revendication 2, ou les revendications 3 à 15 lorsque dépendantes de la revendication 2, dans lequel le motif de couche barrière (213) est composé d'un matériau choisi dans le groupe constitué par Ti, W, Ir, Ru, TiSiₓ, WSi, TiSiN, TaSiN, IrO₂, RuO₂, WN, TiN et les combinaisons de ceux-ci.
